# FASCICULE DE BREVET EUROPEEN

(11) **EP 0 484 224 B1**
(45) Date de publication et mention de la délivrance du brevet: **03.01.1996**
(21) Numéro de dépôt: 91402891.5
(22) Date de dépôt: 29.10.1991
(51) Int. Cl.: H05K 13/04, H05K 13/02, B65D 85/86

(54) **Appareil distributeur de petits objets**
Vorrichtung zum Ausgeben von kleinen Gegenständen
Distributing apparatus for small objects

(30) Priorité: 30.10.1990 FR 9013446
(43) Date de publication de la demande: 06.05.1992
(73) Titulaire: THOMSON TELEVISION ANGERS, F-92400 - Courbevoie (FR)
(72) Inventeur: Goulard, Frédéric, F-92045 Paris la Défense (FR)
(74) Mandataire: Ruellan-Lemonnier, Brigitte

(56) Documents cités:
- DE-A- 3 738 115
- US-A- 4 438 867

## Description

La présente invention concerne un appareil distributeur de petits objets utilisable notamment pour la mise en place de composants électroniques de petite taille sur des cartes de circuits imprimés.

Un tel distributeur est connu de US-A-4438867. Dans ce distributeur les objets à distribuer sont transportés par un cliquet pourvu d'un membre de transport du magasin inséré dans le distributeur vers la tête de distribution.

Il est connu de réaliser la mise en place de composants électroniques sur des cartes de circuits imprimés par un procédé semi-automatique comportant les étapes suivantes :
- pose manuelle des composants dans les alvéoles d'une matrice,
- transfert automatique des composants de la matrice vers une carte de circuits imprimés pré-encollée,
- polymérisation de la colle,
- soudage, par exemple soudage à vague, des composants sur la carte.

A titre d'exemple, les composants électroniques ainsi mis en place sont du type montés en surface (ou CMS) et se présentent sous la forme d'un cylindre pourvu de deux couronnes conductrices assurant les contacts électriques avec les pistes des circuits imprimés sur lesquels ils sont montés. Certains de ces composants, appelés "melfs", présentent une petite taille avec une longueur de 5,9 mm pour un diamètre de 2,2 mm.

D'une façon générale, la pose manuelle des composants reste assez lente et sujette à des erreurs de manipulation (par exemple dues au mélange de composants de références différentes). De plus, le contact direct de la main de l'opérateur sur les surfaces conductrices du composant entraîne des problèmes de qualité de conduction, l'utilisation de gants ou de pincettes rendant alors plus délicate l'opération de pose proprement dite. Enfin la difficulté de pose manuelle est encore accrue avec la tendance à la miniaturisation des composants. En particulier, de nouveaux modèles de "melfs" présentent une longueur de 3,4 mm pour un diamètre de 1,5 mm.

La présente invention a pour but de remédier aux inconvénients mentionnés ci-dessus, sans pour autant avoir recours à des machines de pose complexes et onéreuses.

Plus particulièrement, l'invention propose un appareil distributeur de petits objets comportant un corps pourvu d'un réservoir d'objets et dans lequel est monté coulissant un équipage mobile comprenant un coulisseau mobile selon l'axe longitudinal du corps et percé longitudinalement par un canal d'alimentation présentant une section interne débouchant dans le réservoir et une section externe débouchant à l'extérieur du corps au niveau d'une tête de distribution et ledit equipage mobile comprenant également un tiroir de chargement permettant la sélection unitaire des objets dans ledit canal d'alimentation vers ladite tête de distribution et étant déplaçable en translation dans le coulisseau par des mouvements relatifs du coulisseau par rapport au corps.

Ainsi donc l'appareil distributeur selon l'invention est de structure simple, avec un nombre réduit d'éléments constitutifs, compacte et légère. Il se prête à être utilisé manuellement sans difficulté.

Selon un premier aspect de l'invention, le tiroir est déplaçable dans le coulisseau par coopération d'appui de deux surfaces de glissement prévues sur le tiroir et sur le corps.

Selon un autre aspect de l'invention, le tiroir comporte une cavité adaptée pour recevoir un objet et communiquant sélectivement avec la section interne du canal lorsque le coulisseau est en position de repos par rapport au corps et avec la section externe du canal lorsque le coulisseau est en position de travail. Avantageusement, les sections interne et externe du canal s'étendent parallèlement et de façon décalée l'une par rapport à l'autre et débouchent dans un évidemment transversal dans lequel est monté ledit tiroir.

Selon encore un autre aspect de l'invention, l'appareil distributeur comporte des moyens élastiques de rappel pour solliciter le coulisseau et le tiroir dans leurs positions de repos. Avantageusement, le déplacement des objets dans le canal d'alimentation est obtenu par gravité.

Selon une variante de l'invention, l'extrémité libre de la portion du coulisseau recevant ladite section interne du canal d'alimentation se présente sous la forme d'une projection se projetant à l'intérieur dudit réservoir lorsque le coulisseau est dans sa position de travail.

Selon une autre variante de l'invention, la tête de distribution est adaptée pour coopérer avec une ouverture complémentaire réalisée dans un guide de positionnement des objets.

D'autres caractéristiques et avantages de l'invention apparaîtront à la lecture de la description en référence aux dessins ci-annexés dans lesquels :
- la figure 1 est une vue en coupe longitudinale d'un appareil distributeur selon un mode préféré de l'invention,
- et les figures 2a, 2b, 2c sont des vues aggrandies en coupe longitudinale partielle de l'appareil de la figure 1 montrant la position relative de ses divers éléments constitutifs au cours d'une opération de mise en place d'un composant électronique.

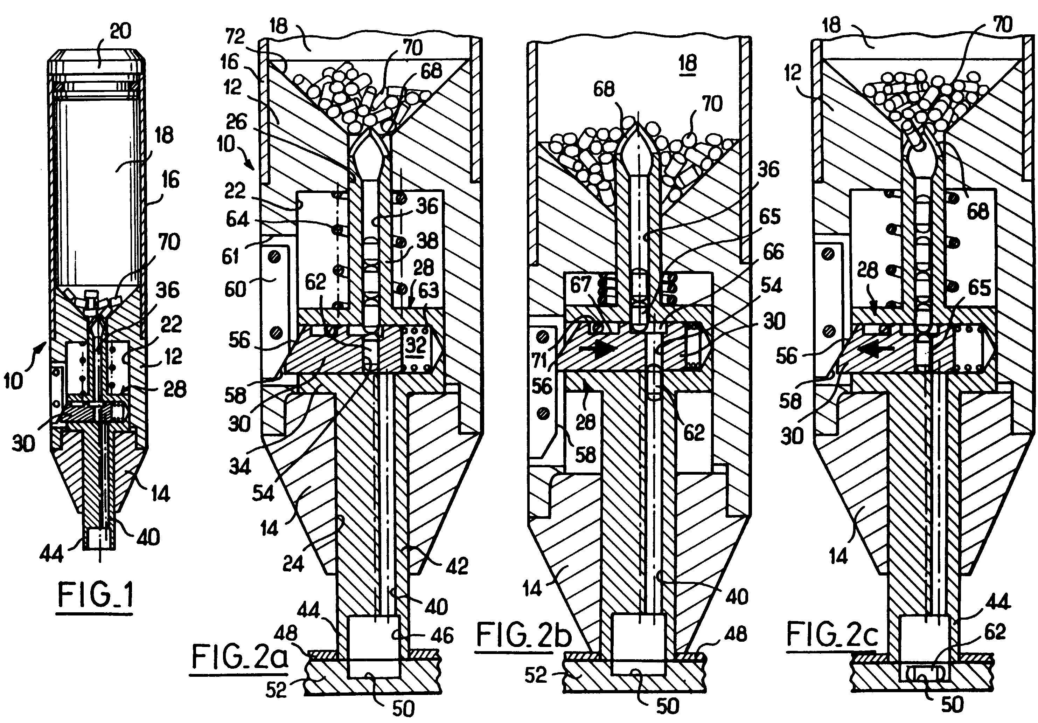

Si l'on considère la figure 1, l'appareil distributeur présente un corps 10 d'allure générale cylindrique et comportant une embase 12 pourvue d'une cavité centrale 22 fermée à sa partie inférieure par un embout conique 14. L'embase 12 est prolongée à sa partie supérieure par un manchon cylindrique 16 en matière plastique transparente et forme avec ce dernier un réservoir 18 fermé par un bouchon 20 et destiné à recevoir en vrac les objets à poser (dans le cas présent des composants électroniques de type "melf"). De préférence, le diamètre extérieur du corps 10 est tel que l'outil distributeur puisse être aisement saisi manuellement par un opérateur.

Comme illustré en détails sur les figures 2a, 2b et 2c, l'embase 12 et l'embout 14 sont percés de deux alésages coaxiaux 24 et 26 parallèles à l'axe longitudinal du corps 10 et débouchant dans la cavité centrale 22 de façon à recevoir un équipage mobile formé d'un coulisseau 28 et d'un tiroir de chargement 30. Le coulisseau mobile, selon l'axe longitudinal du corps 10, présente trois parties, une partie supérieure de petit diamètre 38 coopérant avec l'alésage 26, une partie centrale de grand diamètre 34 coopérant avec la cavité centrale 22 et une partie inférieure de petit diamètre 42 coopérant avec l'alésage 24. Le tiroir 30 est monté coulissant dans un évidemment transversal 32 réalisé dans la partie centrale de grand diamètre 34 du coulisseau. Le coulisseau 28 est percé longitudinalement par un canal d'alimentation dont la section interne 36 est réalisée dans la partie supérieure 38 de petit diamètre du coulisseau et dont la section externe 40 est réalisée dans la partie inférieure 42 de petit diamètre du coulisseau. Comme représentées sur la figure 2a, les deux sections 36 et 40 du canal d'alimentation s'étendent parallèlement et de façon décalée l'une par rapport à l'autre pour déboucher dans l'évidemment transversal 32.

Un ressort de rappel 64 logé dans la cavité centrale 22 sollicite le coulisseau 28 dans sa position de repos avec appui de la partie de grand diamètre 34 sur l'embout 14, position illustrée sur les figures 1, 2a et 2c. Dans cette position de repos, la partie inférieure de petit diamètre 42 du coulisseau se projette à l'extérieur du corps 10 pour former une tête de distribution 44. Pour faciliter la mise en place du composant, la tête de distribution 44 présente une ouverture élargie 46 au débouché de la section externe 40 du canal d'alimentation et une section droite dont le profil extérieur (de façon optionnelle indexée en rotation) est conçu pour coopérer avec une ouverture complémentaire réalisée dans un guide de positionnement (en l'occurence une plaque ajourée 48) disposé au-dessus de l'alvéole 50 de la matrice 52 destiné à recevoir le composant électronique.

Le tiroir de chargement 30 est traversé par une cavité 54 adaptée à recevoir l'objet à poser et communiquant de façon sélective avec la partie interne 36 du canal d'alimentation (lorsque le tiroir occupe sa position de repos illustrée aux figures 2a et 2c) et avec la partie externe 40 du canal d'alimentation (lorsque le tiroir occupe sa position de travail illustrée à la figure 2b). Les déplacements du tiroir 30 sont commandés par les mouvements relatifs du coulisseau 28 par rapport au corps 10 par coopération d'appui de deux surfaces de glissement 56 et 58 respectivement prévues à l'extrémité libre du tiroir et sur une rampe 60 montée de façon réglable dans une rainure 61 réalisée dans l'embase 12 au droit de la cavité centrale 22 et de la portion de grand diamètre 34 du coulisseau 28. Comme illustré sur les figures 2a, 2b et 2c, les surfaces de glissement 56, 58 présentent chacune une partie orientée en oblique par rapport à l'axe longitudinal du corps 10 (et de l'embase 12) suivie d'une partie axiale droite. Un ressort de rappel 63 monté dans l'évidemment 32 sollicite le tiroir 30 vers l'extérieur du coulisseau 28 dans sa position de repos illustrée à la figure 2a. Dans cette position de repos, le premier 62 des composants électroniques présents dans la section interne 36 du canal se met en place par gravité dans la cavité 54 du tiroir de chargement 30 alors en vis-à-vis de la section interne 36 du canal d'alimentation. Lorsque le coulisseau 28 est déplacé à l'encontre du ressort 64, le tiroir 30 est déplacé transversalement vers l'intérieur de l'alésage 32 par action des parties obliques des surfaces de glissement 56, 58, jusqu'à venue en appui des parties axiales droites de ces mêmes surfaces dans la position illustrée à la figure 2b; la position relative des parties axiales droites des surfaces de glissement 56,58 étant telle que dans la position de travail illustrée à la figure 2b, le déplacement du tiroir 30 entraîne la mise en vis-à-vis de la cavité 54 avec la section externe 40 du canal d'alimentation pour permettre au composant 62 de s'échapper vers la tête de distribution 44. Le tiroir 30 présente de plus à sa partie supérieure une rainure 66 pour faciliter le chargement du composant électronique 62 dans la cavité 54 et une rainure 67 recevant une goupille 71 bloquant en rotation le tiroir 30 dans son alésage 32. L'extrémité libre de la partie supérieure de petit diamètre 38 du coulisseau se présente sous la forme d'une projection pointue ajourée 68 se projetant à l'intérieur du réservoir 18 lorsque le coulisseau occupe 28 sa position de travail illustrée à la figure 2b. Le mouvement de cette projection 68 a pour but de remuer l'amas de composants électroniques 70 et de faciliter leur introduction dans la section interne 36 du canal d'alimentation. Pour la même raison, le fond du réservoir constitué par l'embase 12 se présente sous la forme d'un cône d'alimentation 72 dont le sommet est occupé par la pointe ajourée de la projection 68 lorsque le coulisseau 28 est dans sa position de repos illustrée aux figures 2a et 2c.

Le mode opératoire de l'appareil distributeur qui vient d'être décrit est le suivant: Après avoir positionné la grille 48 sur la matrice 52 à équiper, l'opérateur se saisit de l'appareil selon l'invention dont le réservoir est chargé du modèle de composant particulier destiné à l'alvéole 50 (l'opérateur dispose d'une panoplie d'appareils distributeurs selon l'invention, chacun chargé d'un modèle de composant). L'appareil distributeur alors en position de repos, est maintenu verticalement, son embase 12 vers le bas, de façon à placer la tête de distribution 44 dans l'ouverture de la plaque 48 en appui sur la matrice 52 (elle-même en position d'appui fixe sur un bâti) pour occuper la position illustrée à la figure 2a. L'opérateur imprime alors un mouvement vers le bas du corps 10 jusqu'à venue en butée de l'embout conique 34 sur la plaque ajourée 48 pour occuper la position illustrée à la figure 2b. Le composant 62, chargé dans la cavité 54 du tiroir 30, est alors libre de se déplacer par gravité jusqu'à tomber dans l'alvéole 50 de la matrice, le relâchement de la pression de l'opérateur permettant au coulisseau 28 d'occuper de nouveau sa position de repos illustrée à la figure 2c et dans laquelle le composant suivant 65 est chargé à partir de la section interne 36 du canal d'alimentation dans la cavité 54 du tiroir 30.

Il ressort de la description qui précède que l'appareil distributeur selon l'invention est particulièrement compact et léger, très facile à mettre en oeuvre manuellement pour obtenir une pose rapide des composants électroniques. Bien entendu, l'invention est applicable à la mise en place d'autres types d'objets de petite taille. De même, il est possible, dans le cadre de l'invention, d'utiliser l'appareil distributeur sur un poste fixe avec déplacement manuel ou automatique de la matrice ou même d'équiper une machine automatique à bras de préhension d'appareils distributeurs selon l'invention.

## Revendications

1. Appareil distributeur de petits objets comportant un corps (10) pourvu d'un réservoir (18) d'objets (70) et dans lequel est monté coulissant un équipage mobile (28, 30) comprenant un coulisseau (28) mobile selon l'axe longitudinal du corps (10) et percé longitudinalement par un canal d'alimentation présentant une section interne (36) débouchant dans le réservoir (18) et une section externe (40) débouchant à l'extérieur du corps au niveau d'une tête de distribution (44) et ledit équipage mobile (28, 30) comprenant également un tiroir de chargement (30) permettant la sélection unitaire des objets dans ledit canal d'alimentation (36, 40) vers la tête de distribution (44) et étant déplaçable en translation dans le coulisseau (28) par des mouvements relatifs du coulisseau (28) par rapport au corps (10).

2. Appareil selon la revendication 1, caractérisé en ce que le tiroir (30) est déplaçable dans le coulisseau (28) par coopération d'appui de deux surfaces de glissement (56, 58) prévues sur le tiroir (30) et sur le corps (10).

3. Appareil selon l'une des revendications précédentes, caractérisé en ce que le tiroir (30) comporte une cavité (54) adaptée pour recevoir un objet (62) et communiquant sélectivement avec la section interne (36) du canal lorsque le coulisseau (28) est en position de repos par rapport au corps (10) et avec la section externe (40) du canal lorsque le coulisseau est en position de travail.

4. Appareil selon la revendication 3, caractérisé en ce que les sections interne (36) et externe (40) du canal s'étendent parallèlement et de façon décalée l'une par rapport à l'autre et débouchent dans un évidemment transversal (32) dans lequel est monté ledit tiroir.

5. Appareil selon la revendication 4, caractérisé en ce qu'il comporte des moyens élastiques de rappel (63, 64) pour solliciter le coulisseau (28) et le tiroir (30) dans leurs positions de repos.

6. Appareil selon l'une des revendications précédentes, caractérisé en ce que le déplacement des objets (70) dans le canal d'alimentation (36, 40) est obtenu par gravité.

7. Appareil selon l'une des revendications précédentes, caractérisé en ce que l'extrémité libre de la portion de petit diamètre (38) recevant ladite section interne (36) du canal d'alimentation se présente sous la forme d'une projection (68) se projetant à l'intérieur dudit réservoir (18) lorsque le coulisseau (28) est dans sa position de travail.

8. Appareil selon l'une des revendications précédentes, caractérisé en ce que la tête de distribution (44) est adaptée pour coopérer avec une ouverture complémentaire réalisée dans un guide (48) de positionnement des objets.

9. Appareil selon l'une des revendications précédentes, caractérisé en ce qu'il est utilisé manuellement pour la mise en place de composants électroniques sur des cartes de circuits imprimés.

## Patentansprüche

1. Vorrichtung zum Ausgeben von kleinen Gegenständen, die einen Körper (10) umfaßt, der mit einem Behälter (18) mit Gegenständen (70) versehen ist und in dem ein bewegliches Organ (28, 30) gleitend befestigt ist, das einen entlang der Längsachse des Körpers (10) beweglichen und in Längsrichtung von einem Zuführungskanal durchsetzten Schlitten (28) umfaßt, wobei der Zuführungskanal einen im Behälter (18) mündenden inneren Abschnitt (36) und einen in Höhe eines Ausgabekopfs (44) außerhalb des Körpers mündenden äußeren Abschnitt (40) aufweist und das bewegliche Organ (28, 30) des weiteren einen Ladeschieber (30) umfaßt, der die gezielte Auswahl der Gegenstände im Zuführungskanal (36, 40) zum Ausgabekopf (44) hin gestattet und sich durch Relativbewegungen des Schlittens (28) gegenüber dem Körper (10) im Schlitten (28) translatorisch bewegen kann.

2. Vorrichtung nach Anspruch 1, dadurch gekennzeichnet, daß der Schieber (30) durch Anlagezusammenwirkung zweier am Schieber (30) und am Körper (10) vorgesehener Gleitflächen (56, 58) im Schlitten (28) beweglich ist.

3. Vorrichtung nach einem der vorhergehenden Ansprüche, dadurch gekennzeichnet, daß der Schieber (30) einen zur Aufnahme eines Gegenstands (62) bestimmten Hohlraum (54) enthält, der mit dem inneren Abschnitt (36) des Kanals gezielt in Verbindung steht, wenn sich der Schlitten (28) gegenüber dem Körper (10) in Ruhestellung befindet, und mit dem äußeren Abschnitt (40) des Kanals, wenn sich der Schlitten in Arbeitsstellung befindet.

4. Vorrichtung nach Anspruch 3, dadurch gekennzeichnet, daß sich der innere Abschnitt (36) und der äußere Abschnitt (40) des Kanals parallel und versetzt zueinander erstrecken und in einer quer verlaufenden Vertiefung (32) münden, in der der Schieber befestigt ist.

5. Vorrichtung nach Anspruch 4, dadurch gekennzeichnet, daß sie elastische Rückholmittel (63, 64) umfaßt, um den Schlitten (28) und den Schieber (30) in ihre Ruhestellung zu drängen.

6. Vorrichtung nach einem der vorhergehenden Ansprüche, dadurch gekennzeichnet, daß die Bewegung der Gegenstände (70) im Zuführungskanal (36, 40) durch Schwerkraft erreicht wird.

7. Vorrichtung nach einem der vorhergehenden Ansprüche, dadurch gekennzeichnet, daß das freie Ende des Teils (38) mit geringem Durchmesser, der den inneren Abschnitt (36) des Zuführungskanals aufnimmt, als Vorsprung (68) ausgebildet ist, der ins Innere des Behälters (18) vorsteht, wenn sich der Schlitten (28) in seiner Arbeitsstellung befindet.

8. Vorrichtung nach einem der vorhergehenden Ansprüche, dadurch gekennzeichnet, daß der Ausgabekopf (44) so ausgelegt ist, daß er mit einer in einer Führung (48) zur Positionierung der Gegenstände ausgebildeten komplementären Öffnung zusammenwirkt.

9. Vorrichtung nach einem der vorhergehenden Ansprüche, dadurch gekennzeichnet, daß sie manuell zum Anbringen von elektronischen Bauteilen auf Leiterplatten verwendet wird.

## Claims

1. Apparatus for dispensing small objects, which includes a body (10) provided with a reservoir (18) of objects (70) and in which is slidably mounted a movable assembly (28, 30) comprising a slide (28) which can move along the longitudinal axis of the body (10) and pierced longitudinally by a feed channel having an inner section (36) running into the reservoir (18) and an outer section (40) running to the outside of the body at a dispensing head (44) and the said movable assembly (28, 30) also comprising a loading slide valve (30) allowing unitary selection of the objects from the said feed channel (36, 40) to the dispensing head (44) and being able to move translationally in the slide (28) by relative movements of the slide (28) with respect to the body (10).

2. Apparatus according to Claim 1, characterized in that the slide valve (30) can move in the slide (28) by bearing cooperation of two sliding surfaces (56, 58) provided on the slide valve (30) and on the body (10).

3. Apparatus according to one of the preceding claims, characterized in that the slide valve (30) includes a cavity (54) designed to accommodate an object (62) and selectively communicating with the inner section (36) of the channel when the slide (28) is in the rest position with respect to the body (10) and with the outer section (40) of the channel when the slide is in the working position.

4. Apparatus according to Claim 3, characterized in that the inner section (36) and outer section (40) of the channel extend in a mutually parallel and an offset manner and run into a transverse obviously [sic] (32) in which the said slide valve is mounted.

5. Apparatus according to Claim 4, characterized in that it includes elastic return means (63, 64) for urging the slide (28) and the slide valve (30) into their rest positions.

6. Apparatus according to one of the preceding claims, characterized in that the objects (70) move in the feed channel (36, 40) under gravity.

7. Apparatus according to one of the preceding claims, characterized in that the free end of the small-diameter portion (38) accommodating the said inner section (36) of the feed channel takes the form of a projection (68) projecting inside the said reservoir (18) when the slide (28) is in its working position.

8. Apparatus according to one of the preceding claims, characterized in that the dispensing head (44) is designed to cooperate with a complementary opening made in a guide (48) for positioning the objects.

9. Apparatus according to one of the preceding claims, characterized in that it is used manually for placing electronic components on printed-circuit boards.
